# EUROPÄISCHE PATENTSCHRIFT

(11) **EP 2 950 627 B1**
(45) Veröffentlichungstag und Bekanntmachung des Hinweises auf die Patenterteilung: **04.07.2018**
(21) Anmeldenummer: 15001399.3
(22) Anmeldetag: 08.05.2015
(51) Int. Cl.: H05K 9/00

(54) **KRAFTFAHRZEUG SOWIE HPEM REFLEKTOR FÜR EIN KRAFTFAHRZEUG**
MOTOR VEHICLE AND HPEM REFLECTOR FOR A MOTOR VEHICLE
VÉHICULE AUTOMOBILE ET RÉFLECTEUR ÉLECTROMAGNÉTIQUE À HAUTE PUISSANCE POUR UN VÉHICULE AUTOMOBILE

(30) Priorität: 28.05.2014 DE 102014008216
(43) Veröffentlichungstag der Anmeldung: 02.12.2015
(73) Patentinhaber: Diehl Defence GmbH & Co. KG, 88662 ÜBERLINGEN (DE)
(72) Erfinder: Ganghofer, Andreas, 90552 Röthenbach (DE); Bähr, Markus, 91327 Gößweinstein (DE)
(74) Vertreter: Diehl Patentabteilung

(56) Entgegenhaltungen:
- DE-A1- 3 022 154
- DE-A1- 4 221 479
- US-A- 4 997 993
- "HPEMcarStop Non-violent system for selective stopping of vehicles in dynamic scenarios", , 30. April 2013 (2013-04-30), Seiten 1-4, XP055222416, 90552 Rothenbach an der Pegnitz Gefunden im Internet: URL:http://www.diehl.com/fileadmin/diehl-d efence/user_upload/flyer/HPEMcarStop_Flyer .pdf [gefunden am 2015-10-20]
- Dr D V Giri ET AL: "An Overview of High-Power Electromagnetic (HPEM) Radiating and Conducting Systems", , 24. Februar 2006 (2006-02-24), XP055222547, Gefunden im Internet: URL:http://www.researchgate.net/profile/D_ V_Giri/publication/228681326_An_Overview_o f_High-Power_Electromagnetic_(HPEM)_Radiat ing_and_Conducting_Systems/links/004635328 859d7d96c000000.pdf?inViewer=true&pdfJsDow nload=true&disableCoverPage=true&origin=pu blication_detail [gefunden am 2015-10-20]

## Beschreibung

Die Erfindung betrifft ein Kraftfahrzeug umfassend eine Karosserie mit einer mittels einer, vorzugsweise schwenkbaren, Abdeckung verschließbaren Öffnung sowie einen in diese Öffnung lösbar einsetzbaren, kastenförmigen und zur Öffnung hin offenen metallenen Reflektor zur Aufnahme eine HPEM-Quelle, wobei der Reflektor nach dem Einsetzen mit der Karosserie über eine Masseverbindung verbunden ist.

Eine HPEM (High-Power-Electromagnetics)-Quelle oder ein solches Wirksystem bietet die Möglichkeit, gezielt Störimpulse in elektronische Systeme zu lenken, um auf diese Weise deren Funktionsfähigkeit zu blockieren. Hierüber ist es beispielsweise möglich, Sprengfallen zu deaktivieren, Fahrzeuge durch Eingriff in deren Elektronik zu stoppen und Ähnliches. Es handelt sich um ein rein auf der Wirkung elektromagnetischer Pulse mit hoher Energiedichte arbeitendes System, das zu keinen dauerhaften Schädigungen der Elektronik führt.

Dabei ist es bekannt, eine mobile HPEM-Quelle in einem Fahrzeug anzuordnen. Hierzu wird ein Reflektor, der die HPEM-Quelle einhaust, in eine entsprechende Öffnung des Fahrzeugs eingesetzt. Bevorzugt wird hierbei ein Fahrzeug mit Heckklappe, beispielsweise in Form eines geländegängigen SUV (Sport Utility Vehicle), das eine gewisse Robustheit und mitunter auch Geländegängigkeit aufweist. Der Reflektor ist eine Metalleinhausung, die allseits geschlossen ist und nur an einer Seite, die zur Öffnung weist, offen ist, so dass die im Reflektor angeordnete HPEM-Quelle bei geöffneter Abdeckung respektive Heckklappe nach außen abstrahlen kann. Zum Schutz des eigenen Fahrzeugs ist es erforderlich, den Reflektor mit der Fahrzeugmasse zu verbinden, ihn also über eine Masseverbindung mit der Karosserie zu koppeln. Erforderlich ist eine möglichst lückenlose Kontaktierung um den gesamten Umfang des Reflektors, was mitunter aufgrund der räumlich komplexen Form der karosserieseitigen Öffnung und die gegebenen Formunterschiede zum Reflektorgehäuse mitunter schwierig ist. Werden zur Masseverbindung leitfähige elastische Elemente wie Dichtgummis eingesetzt, so sind diese zwar flexibel verlegbar, sie können aber nur relativ geringe Abstandsunterschiede ausgleichen, so dass, insbesondere bei sich bewegendem Fahrzeug, eine zuverlässige Masseverbindung nicht immer gegeben ist.

Der Erfindung liegt damit das Problem zugrunde, ein Kraftfahrzeug anzugeben, das ein einfaches und robustes Verbinden des eingesetzten Reflektors mit der Karosseriemasse ermöglicht.

Zur Lösung dieses Problems ist bei einem Kraftfahrzeug der eingangs genannten Art erfindungsgemäß vorgesehen, dass die Masseverbindung mittels einer Bürstenleiste umfassend Fasern aus einem leitfähigen Material realisiert ist, die den kastenförmigen Reflektor allseitig umlaufend mit der Karosserie im Bereich der Öffnung verbindet.

Zur Realisierung der Masseverbindung kommt erfindungsgemäß eine Bürstenleiste umfassend leitfähige Fasern zum Einsatz, wobei als Fasern bevorzugt Metallfasern, insbesondere Edelstahlfasern verwendet werden, jedoch auch andere leitfähige Fasermaterialien genutzt werden können, solange sie insbesondere ozonresistent sind und Oberflächenströme tragen können. Diese Bürstenleiste ist, worauf nachfolgend noch eingegangen wird, entweder karosserieseitig oder reflektorseitig angeordnet und erstreckt sich zum jeweiligen anderen, zu kontaktierenden Teil. Die Fasern sind flexibel und weisen eine entsprechende Länge auf, so dass es mit dieser Bürstenleiste möglich ist, auch größere Abstände zwischen Karosserie und Reflektor überbrücken zu können. Der metallene Reflektor ist lediglich in die Öffnung einzuschieben, wobei es spätestens mit Erreichen der Einsetzendstellung dazu kommt, dass die Bürstenleiste respektive die Fasern umgebogen werden, da die Fasern eine hinreichende Länge aufweisen, und über eine hinreichende Länge, beispielsweise 20 bis 30 mm, am jeweiligen gegenüberliegenden Teil kontaktierend anliegen. Da die Bürstenleiste und damit der Faserzug umlaufend angeordnet ist, ist folglich eine vollständig umlaufende Masseverbindung zwischen Reflektor und Karosseriemasse gegeben. Die Masseverbindung wird vorzugsweise durch eine flexible und/oder durchgängige und/oder leitende und/oder verschiebbare und/oder drehbare Masseanbindung oder elektrische Anbindung realisiert.

Nach einer ersten Erfindungsalternative kann dabei die Bürstenleiste an der Karosserie im Bereich der Öffnung angeordnet sein, wobei die in die Öffnung hineinragenden Fasern den eingesetzten Reflektor außenseitig kontaktieren. Die Bürstenleiste kann beispielsweise durch Verlöten oder Verschweißen mit der Karosserie elektrisch leitfähig verbunden sein, worüber natürlich die Fasern entsprechend mit der Karosserie kontaktiert sind. Wird nun der Reflektor in die Öffnung eingeschoben, so wird er beim Einschieben automatisch gegen die nach innen ragenden Fasern gedrückt. Diese werden umgebogen und legen sich bei weiterem Einschieben an die Außenseite des Reflektors, diesen kontaktierend, an.

Alternativ zur Anordnung der Bürstenleiste an der Karosserie ist es selbstverständlich auch denkbar, die Bürstenleiste an dem Reflektor anzuordnen, wiederum beispielsweise durch Anlöten oder Anschweißen, wobei die vom Reflektor seitlich abragenden Fasern nach Einsetzen des Reflektors die Karosserie an im Bereich der Öffnung vorgesehenen Kontaktflächen kontaktieren. Bei dieser Erfindungsausgestaltung wird der Massekontakt erst kurz vor oder mit Erreichen der Einsetzendstellung erreicht, nachdem die Bürstenleiste im Bereich des offenen Endes des Reflektors angeordnet ist und die Kontaktstellen im Bereich der Fahrzeugöffnung vorgesehen sind. Auch hier ist die Funktion vergleichbar zur zuvor beschriebenen Ausgestaltung, denn mit Erreichen der Kontaktposition werden auch hier die Fasern, sich an die Kontaktstellen anlegend, umgebogen respektive umgelegt und liegen über eine längere Strecke an den Kontaktflächen an.

Der Reflektor selbst ist bevorzugt derart dimensioniert, dass er im Bereich der Öffnung endet und die Öffnung bei eingesetztem Reflektor mittels der Abdeckung verschließbar ist. Dies ermöglicht auch ohne Weiteres einen Transport des Reflektors im geschlossenen Fahrzeug. Der Massekontakt geht hierbei selbst bei stärkeren Fahrzeugbewegungen nicht verloren, da wie beschrieben die Fasern mit hinreichender Überdeckungslänge das jeweilige Gegenüber kontaktieren und aufgrund hinreichend hoher Faserdichte stets ein dauerhafter Massekontakt gegeben ist.

Die Länge der Fasern sollte wenigstens 50 mm, insbesondere wenigstens 100 mm betragen, wobei die endgültige Faserlänger natürlich von den Abstandsverhältnissen zwischen Reflektor und Fahrzeugöffnung abhängt. Sie sollte so gewählt werden, dass in jedem Fall eine Umlege- oder Überdeckungslinie von 2 bis 3 cm in der Kontaktposition gegeben ist. Da sich die Reflektorgeometrie, die letztlich auch in Bezug auf die Karosserieöffnung gewählt ist, nicht ändert, ist es möglich, die Fasern auch individuell zu beschneiden, so dass sie in Bereichen geringeren Abstands etwas verkürzt werden können.

Die Faserdicke sollte kleiner 1 mm, insbesondere kleiner 0,5 mm, idealerweise kleiner 0,1 mm sein, so dass die Fasern hinreichend flexibel sind und sich ohne Weiteres umlegen, aber auch wieder aufrichten können. Auch kann die Besatzdichte bei relativ dünnen Fasern entsprechend hoch gewählt werden. Die Faserbesatzdichte ist derart gewählt, dass der Luftaustausch zwischen dem Inneren des Reflektors und dem Inneren des Fahrzeugs, also der Fahrgastzelle, möglichst gering ist, so dass sich beim Betrieb der HPEM-Quelle bildendes Ozon nicht in die Fahrgaszelle gelangt.

Wie beschrieben sind die Fasern vorzugsweise aus Metall, insbesondere Edelstahl. Denkbar sind aber auch Fasern aus anderen leitfähigen Metallen oder Kohlenstoffnanoröhrchen und Ähnliches.

Neben dem Kraftfahrzeug betrifft die Erfindung ferner einen Reflektor für ein solches Kraftfahrzeug wie zuvor beschrieben. Dieser bis auf eine Seite geschlossene kastenförmige Reflektor zeichnet sich dadurch aus, dass er eine im Bereich der offenen Seite angeordnete, umlaufende Bürstenleiste umfassend Fasern aus einem leitfähigen Material, die mit dem Reflektor in elektrischem Kontakt stehen, aufweist. Dieser Reflektor ist also mit der Bürstenleiste versehen, die die Masseverbindung mit dem Einsetzen des Reflektors in das Fahrzeug erwirkt.

Die Bürstenleiste ist bevorzugt mit dem Reflektor verlötet oder verschweißt oder anderweitig formschlüssig und/oder stoffschlüssig elektrisch leitend verbunden, wobei die Fasern hierüber mit dem metallenen Reflektor kontaktiert sind. Die Fasern selbst weisen eine Länge von wenigstens 50 mm, insbesondere von wenigstens 100 mm auf, bei einer bevorzugten Dicke ≤ 1 mm, insbesondere ≤ 0,5 mm.

Die Fasern sind wie bereits beschrieben vorzugsweise aus Metall, insbesondere aus Edelstahl. Sie können aber auch aus anderen hinreichend leitfähigen Materialien sein.

Weitere Vorteile, Merkmale und Einzelheiten der Erfindung ergeben sich aus den im Folgenden beschriebenen Ausführungsbeispielen sowie anhand der Zeichnungen. Dabei zeigen:
- Fig. 1: eine Prinzipdarstellung eines erfindungsgemäßen Kraftfahrzeugs mit noch nicht eingesetztem Reflektor,
- Fig. 2: eine Prinzipdarstellung des Verbindungsbereichs von Faserbürstenleiste zur Karosserie ohne eingesetzten Reflektor,
- Fig. 3: den Faserverlauf mit eingesetztem Reflektor,
- Fig. 4: eine Prinzipdarstellung des Kraftfahrzeugs aus Fig. 1 mit eingesetztem Reflektor, und
- Fig. 5: einen Reflektor einer zweiten Ausführungsform mit eigener umlaufend angeordneter Bürstenleiste.

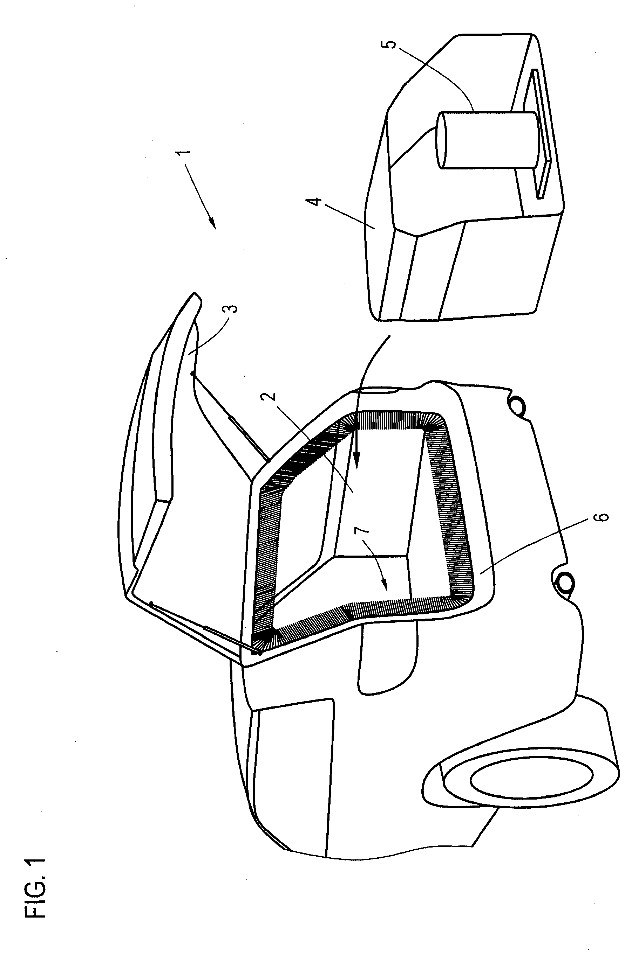

Fig. 1 zeigt ein erfindungsgemäßes Kraftfahrzeug 1, das heckseitig eine Öffnung 2 aufweist, die über eine Heckklappe 3 in an sich bekannter Weise verschlossen werden kann. Bei dem Kraftfahrzeug 1 handelt es sich beispielsweise um ein SUV. Es kann sich aber beispielsweise auch um einen Lkw, einen Transporter, einen Kombi handeln.

In die Öffnung 2, also den Kofferraum, ist ein Reflektor 4 einzusetzen, der eine metallene Einhausung für eine HPEM-Quelle 5, die hier nur angedeutet ist, bildet. Der Reflektor 4 ist an allen Seiten geschlossen, bis auf die Vorderseite, über die die HPEM-Quelle 5 oder eine andere elektromagnetische Quelle (Radiosender, UWB, Jammer, etc.) eingesetzt ist, und die in der Einsetzstellung zur Öffnung 2 weist.

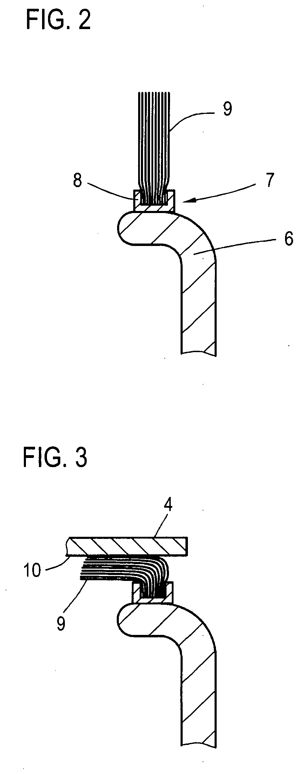

Um den Reflektor 4 über eine Masseverbindung mit der Karosserie 6 des Fahrzeugs zu verbinden (Potentialausgleich), ist im gezeigten Ausführungsbeispiel karosserieseitig eine Bürstenleiste 7 vorgesehen, die - siehe beispielsweise Fig. 2 - über einen Leistenhalter 8 verfügt, über den sie mit der Karosserie 6 beispielsweise verlötet oder verschweißt ist. Im Leistenhalter 8 ist eine Vielzahl von Fasern 9 aufgenommen, die durch die Anordnung der Bürstenleiste 7 an der Karosserie 6 elektrisch leitend mit der Karosserie 6 verbunden sind. Bei den Fasern 9 handelt es sich um metallisch leitfähige Fasern, beispielsweise Edelstahl- oder Kupferfasern oder beispielsweise Fasern aus leitfähigem Kunststoff. Die Fasern, die vorzugsweise eine Faserdicke ≤ 0,5 mm besitzen, weisen eine Länge von beispielsweise 8 bis 10 cm auf. Sie ragen in das Innere der Öffnung 2, wie Fig. 1 deutlich zeigt. Die Bürstenleiste 7 ist vollständig umlaufend um die Öffnung 2 angeordnet und elektrisch leitfähig mit der Karosserie 6 verbunden, so dass sich folglich ein umlaufender massebildender Faserzug ergibt, wie Fig. 1 zeigt. Dabei kann der Reflektor 4 nicht nur in ein Fahrzeug, sondern beispielsweise auch in eine stationäre Anlage eingesetzt werden.

Wird nun der Reflektor 4 in die Öffnung 2 eingesetzt, so läuft er bereits mit dem Einsetzen beginnend zwangsläufig gegen die nach innen in die Öffnung 2 ragenden Fasern 9, da der Abstand der Fasern von einer Seite zur gegenüberliegenden Seite respektive von der Oberseite zur Unterseite kleiner ist, als die jeweiligen Flächen des Reflektors 4 voneinander beabstandet sind. Es kommt nun zwangsläufig dazu, dass die Fasern 9 umgelegt werden, wie exemplarisch in der Prinzipdarstellung gemäß Fig. 3 zeigt ist. Die Fasern 9 biegen sich also und legen sich an die Außenseite 10 des Reflektors 4 respektive der jeweiligen Reflektorwand an. Es ergibt sich eine hinreichende Anlagelänge, so dass, selbst wenn der Abstand von Reflektorwand zur Bürstenleiste nicht überall gleich ist, in Verbindung mit der Faserlänge stets eine hinreichende Kontaktlänge gegeben ist.

Da die Bürstenleiste 7 und damit der Faserzug vollständig um die Öffnung 2 umläuft, ist zwangsläufig eine umlaufende Masseverbindung zwischen Reflektor 4 und Karosserie 6 gegeben, die sich automatisch beim Einschieben des Reflektors 4 in die Öffnung 2 ergibt. Mit Erreichen der Endstellung ist folglich die Masseverbindung gegeben. Aufgrund der Überdeckungslänge der Fasern ist die Masseverbindung selbst dann dauerhaft gewährleistet, wenn das Fahrzeug fährt, da etwaige Relativbewegungen des Reflektors zur Karosserie ohne Weiteres kompensiert werden können. D. h., dass auch nach längerer Fahrt die Einsatzbereitschaft sichergestellt ist, da die Masseverbindung in jedem Fall gegeben ist.

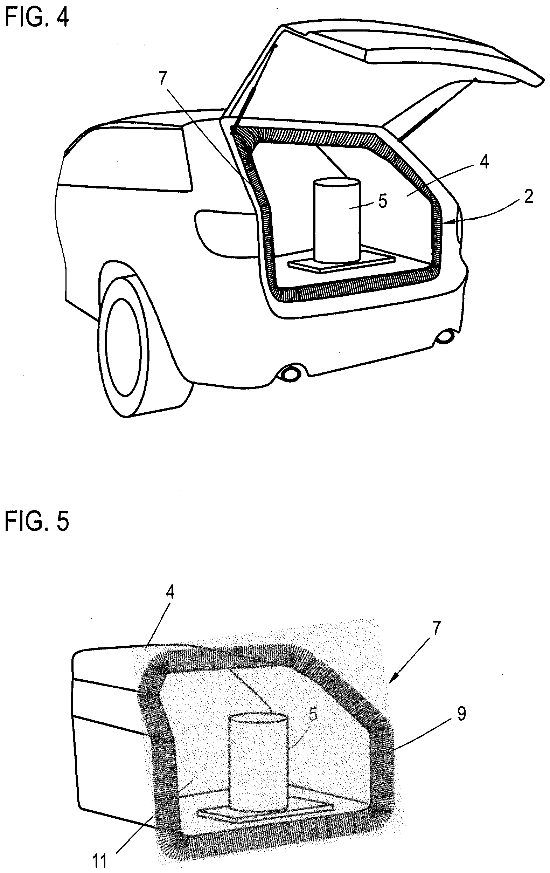

Fig. 4 zeigt in Form einer Prinzipdarstellung den Reflektor 4, wie er in die Öffnung 2 eingesetzt ist. Ersichtlich sind die Fasern 7 allseitig umgebogen, so dass die allseitige Masseverbindung gegeben ist.

Bei dem zuvor beschriebenen Ausführungsbeispiel ist die Bürstenleiste 7 karosserieseitig angelötet oder angeschweißt, ist also fester Bestandteil des Kraftfahrzeugs. Fig. 5 zeigt eine Alternativausgestaltung, bei der die Bürstenleiste 7 am Reflektor 4 angeordnet ist. Die Bürstenleiste 7 ist dabei wiederum über einen entsprechenden leitfähigen Bürstenhalter 8 mit dem metallenen Reflektor 4 verlötet oder verschweißt, so dass die Fasern 9 entsprechend kontaktiert sind. Auch läuft die Bürstenleiste 7 vollständig um die Öffnung des Reflektors herum, so dass mit dem Einschieben des Reflektors 4 in die Öffnung 2 des Kraftfahrzeugs 1 wiederum eine umlaufende Kontaktierung möglich ist. Die Bürstenleiste 7 befindet sich hierbei nahe der Öffnung 11 des Reflektors 4, da sie in der Einsetzendstellung die Masseverbindung zur Karosserie 6 wiederum im Bereich der Öffnung 2 des Kraftfahrzeugs 1 sicherstellen sollen. Karosserieseitig sind hierfür entsprechende Kontaktflächen vorgesehen, an die sich die auch hier umgebogenen Fasern 9 über eine entsprechende Kontaktlänge anlegen. Die Fasern 9 legen sich hier jedoch in die entgegengesetzte Richtung, verglichen zur Darstellung gemäß Fig. 3, um, nachdem der Reflektor 4 in die Öffnung 2 eingeschoben wird und hierbei die Fasern 9 gegen die Karosserie 6 laufen.

Ersichtlich ist es unter Verwendung der Bürstenleiste mit den leitfähigen Fasern möglich, eine flexible, lückenlose und niederohmige Masseverbindung des zu erdenden Reflektors sicherzustellen, auch wenn größere Strecken zu überwinden sind und insbesondere die Abstände aufgrund der Geometrie der zu verbindenden Kontaktflächen, die nicht unbedingt parallel zueinander verlaufen, variieren, wie dies im gezeigten Ausführungsbeispiel mit der eine komplexe Geometrie aufweisenden Kraftfahrzeugöffnung der Fall ist. Somit wird auf eine besonders effiziente Weise eine Trennung von Strahlungsbereich und angrenzendem Schutzbereich realisiert.

### Bezugszeichenliste

- 1: Kraftfahrzeug
- 2: Öffnung
- 3: Heckklappe
- 4: Reflektor
- 5: HPEM-Quelle
- 6: Karosserie
- 7: Bürstenleiste
- 8: Leistenhalter
- 9: Faser
- 10: Außenseite
- 11: Öffnung

## Patentansprüche

1. Kraftfahrzeug (1) umfassend eine Karosserie (6) mit einer mittels einer Abdeckung (3) verschließbaren Öffnung (2) sowie einen in diese Öffnung (2) lösbar einsetzbaren, kastenförmigen und zur Öffnung (2) hin offenen metallenen Reflektor (4) zur Aufnahme einer HPEM-Quelle (5),
wobei der Reflektor (4) nach dem Einsetzen mit der Karosserie (6) über eine Masseverbindung verbunden ist,
**dadurch gekennzeichnet,**
**dass** die Masseverbindung mittels einer Bürstenleiste (7) umfassend Fasern (9) aus einem leitfähigen Material realisiert ist, die den kastenförmigen Reflektor (4) allseitig umlaufend mit der Karosserie (6) im Bereich der Öffnung (2) verbindet, und
**dass** die Faserbesatzdichte derart gewählt ist, dass der Luftaustausch zwischen dem Inneren des Reflektors (4) und der Fahrgastzelle des Kraftfahrzeugs (1) möglichst gering ist, so dass sich beim Betrieb der HPEM-Quelle (5) bildendes Ozon nicht in die Fahrgastzelle gelangt.

2. Kraftfahrzeug nach Anspruch 1,
**dadurch gekennzeichnet,**
**dass** die Bürstenleiste (7) an der Karosserie (6) im Bereich der Öffnung (2) angeordnet ist, wobei die in die Öffnung (2) hineinragenden Fasern (9) den eingesetzten Reflektor (4) außenseitig kontaktieren.

3. Kraftfahrzeug nach Anspruch 1,
**dadurch gekennzeichnet,**
**dass** die Bürstenleiste (7) an dem Reflektor (4) angeordnet ist, wobei die vom Reflektor (4) seitlich abragenden Fasern (9) nach Einsetzen des Reflektors (4) die Karosserie (6) an im Bereich der Öffnung (2) vorgesehenen Kontaktflächen kontaktieren.

4. Kraftfahrzeug nach einem der vorangehenden Ansprüche,
**dadurch gekennzeichnet,**
**dass** der Reflektor (4) derart dimensioniert ist, dass er im Bereich der Öffnung (2) endet und die Öffnung (2) bei eingesetztem Reflektor (4) mittels der Abdeckung (3) verschließbar ist.

5. Kraftfahrzeug nach einem der vorangehenden Ansprüche,
**dadurch gekennzeichnet,**
**dass** die Fasern (9) eine Länge von wenigstens 50 mm aufweisen.

6. Kraftfahrzeug nach einem der vorangehenden Ansprüche,
**dadurch gekennzeichnet,**
**dass** die Faserdicke ≤ 1 mm ist.

7. Kraftfahrzeug nach einem der vorangehenden Ansprüche,
**dadurch gekennzeichnet,**
**dass** die Fasern (9) aus Metall sind.

8. Kraftfahrzeug nach einem der vorangehenden Ansprüche,
**dadurch gekennzeichnet,**
**dass** die Öffnung (2) eine über eine Heckklappe (3) verschließbare Hecköffnung ist.

9. Reflektor für ein Kraftfahrzeug (1) nach einem der vorangehenden Ansprüche,
**dadurch gekennzeichnet,**
**dass** der bis auf eine Seite (11) geschlossene, kastenförmige Reflektor (4) eine im Bereich der offenen Seite (11) angeordnete, umlaufende Bürstenleiste (7) umfassend Fasern (9) aus einem leitfähigen Material, die mit dem Reflektor (4) in elektrischem Kontakt stehen, aufweist, und
**dass** die Faserbesatzdichte derart gewählt ist, dass der Luftaustausch zwischen dem Inneren des Reflektors (4) und der Fahrgastzelle des Kraftfahrzeugs (1) möglichst gering ist, so dass sich beim Betrieb der HPEM-Quelle (5) bildendes Ozon nicht in die Fahrgastzelle gelangt.

10. Reflektor nach Anspruch 9,
**dadurch gekennzeichnet,**
**dass** die Bürstenleiste (7) mit dem Reflektor (4) verlötet oder verschweißt ist.

11. Reflektor nach Anspruch 9 oder 10,
**dadurch gekennzeichnet,**
**dass** die Fasern (9) eine Länge von wenigstens 50 mm aufweisen.

12. Reflektor nach einem der Ansprüche 9 bis 11,
**dadurch gekennzeichnet,**
**dass** die Faserdicke ≤ 1 mm ist.

13. Reflektor nach einem der Ansprüche 9 bis 12,
**dadurch gekennzeichnet,**
**dass** die Fasern (9) aus Metall sind.

## Claims

1. Motor vehicle (1) comprising a body (6) with an opening (2) that can be closed by means of a cover (3) and a box-shaped metallic reflector (4) that is open towards the opening (2) for receiving an HPEM source (5) and that can be reversibly inserted into said opening (2),
wherein following insertion the reflector (4) is connected to the body (6) by means of an earth connection,
**characterized in that**
the earth connection is implemented by means of a brush strip (7) comprising fibres (9) made of a conductive material, which connects the box-shaped reflector (4) to the body (6) circumferentially on all sides in the region of the opening (2), and
the fibre packing density is selected such that the air exchange between the interior of the reflector (4) and the passenger compartment of the motor vehicle (1) is as small as possible, so that ozone formed when operating the HPEM source (5) does not pass into the passenger compartment.

2. Motor vehicle according to Claim 1,
**characterized in that**
the brush strip (7) is disposed on the body (6) in the region of the opening (2), wherein the fibres (9) protruding into the opening (2) contact the outside of the inserted reflector (4).

3. Motor vehicle according to Claim 1,
**characterized in that**
the brush strip (7) is disposed on the reflector (4), wherein the fibres (9) protruding laterally from the reflector (4) contact the body (6) on the contact surfaces provided in the region of the opening (2) following insertion of the reflector (4) .

4. Motor vehicle according to any one of the preceding claims,
**characterized in that**
the reflector (4) is dimensioned such that it ends in the region of the opening (2) and the opening (2) can be closed by means of the cover (3) with the reflector (4) inserted.

5. Motor vehicle according to any one of the preceding claims,
**characterized in that**
the fibres (9) have a length of at least 50 mm.

6. Motor vehicle according to any one of the preceding claims,
**characterized in that**
the fibre thickness is ≤ 1 mm.

7. Motor vehicle according to any one of the preceding claims,
**characterized in that**
the fibres (9) are made of metal.

8. Motor vehicle according to any one of the preceding claims,
**characterized in that**
the opening (2) can be closed by means of a tailgate (3).

9. Reflector for a motor vehicle (1) according to any one of the preceding claims,
**characterized in that**
the box-shaped reflector (4), which is closed apart from one side (11), comprises a circumferential brush strip (7) comprising fibres (9) of a conductive material disposed in the region of the open side (11) and in electrical contact with the reflector (4), and
the fibre packing density is selected such that the air exchange between the interior of the reflector (4) and the passenger compartment of the motor vehicle (1) is as small as possible, so that ozone formed when operating the HPEM source (5) does not pass into the passenger compartment.

10. Reflector according to Claim 9,
**characterized in that**
the brush strip (7) is soldered or welded to the reflector (4).

11. Reflector according to Claim 9 or 10,
**characterized in that**
the fibres (9) have a length of at least 50 mm.

12. Reflector according to any one of Claims 9 to 11,
**characterized in that**
the fibre thickness is ≤ 1 mm.

13. Reflector according to any one of Claims 9 to 12,
**characterized in that**
the fibres (9) are made of metal.

## Revendications

1. Véhicule automobile (1) comprenant une carrosserie (6) dotée d'une ouverture (2) qui peut être fermée par un couvercle (3), ainsi qu'un réflecteur métallique (4) ouvert en direction de l'ouverture (2), en forme de caisson et apte à être inséré de manière libérable dans cette ouverture (2) en vue de la reprise d'une source HPEM (5),
le réflecteur (4) étant relié à la carrosserie (6) par une liaison à la masse après son insertion, **caractérisé en ce que**
la liaison à la masse est réalisée au moyen d'une latte (7) de brosses comprenant des fibres (9) en matériau conducteur qui relient le réflecteur (4) en forme de caisson en l'entourant sur tous ses côtés à la carrosserie (6) au niveau de l'ouverture (2) et
**en ce que** la densité d'occupation des fibres est sélectionnée de telle sorte que l'échange d'air entre l'intérieur du réflecteur (4) et l'habitacle du véhicule automobile (1) soit aussi faible que possible de telle sorte que lorsque la source HPEM (5) est en fonctionnement, l'ozone formé n'aboutisse pas dans l'habitacle du véhicule.

2. Véhicule automobile selon la revendication 1, **caractérisé en ce que** la latte (7) de brosses est disposée sur la carrosserie (6) au niveau de l'ouverture (2), les fibres (9) pénétrant dans l'ouverture (2) étant en contact avec l'extérieur du réflecteur (4) qui y a été inséré.

3. Véhicule automobile selon la revendication 1, **caractérisé en ce que** la latte (7) de brosses est disposée sur le réflecteur (4), les fibres (9) débordant latéralement du réflecteur (4) étant en contact après l'insertion du réflecteur (4) avec la carrosserie (6) sur des surfaces de contact prévues au niveau de l'ouverture (2).

4. Véhicule automobile selon l'une des revendications précédentes, **caractérisé en ce que** le réflecteur (4) est dimensionné de telle sorte qu'il se termine au niveau de l'ouverture (2) et que lorsque le réflecteur (4) a été inséré, l'ouverture (2) puisse être fermée au moyen du couvercle (3).

5. Véhicule automobile selon l'une des revendications précédentes, **caractérisé en ce que** les fibres (9) ont une longueur d'au moins 50 mm.

6. Véhicule automobile selon l'une des revendications précédentes, **caractérisé en ce que** l'épaisseur des fibres est ≤ 1 mm.

7. Véhicule automobile selon l'une des revendications précédentes, **caractérisé en ce que** les fibres (9) sont réalisées en métal.

8. Véhicule automobile selon l'une des revendications précédentes, **caractérisé en ce que** l'ouverture (2) est une ouverture arrière qui peut être fermée par un hayon arrière (3).

9. Réflecteur pour un véhicule automobile (1) selon l'une des revendications précédentes, **caractérisé en ce que** le réflecteur (4) en forme de caisson, fermé sauf sur un côté (11), présente une latte (7) à brosses périphérique, disposée au niveau du côté ouvert (11) et comprenant des fibres (9) en un matériau conducteur en contact électrique avec le réflecteur (4) et **en ce que** la densité d'occupation des fibres est sélectionnée de telle sorte que l'échange d'air entre l'intérieur du réflecteur (4) et l'habitacle du véhicule automobile (1) soit aussi faible que possible de telle sorte que lorsque la source HPEM (5) est en fonctionnement, l'ozone formé n'aboutisse pas dans l'habitacle du véhicule.

10. Réflecteur selon la revendication 9, **caractérisé en ce que** la latte (7) à brosses est brasée ou soudée sur le réflecteur (4).

11. Réflecteur selon les revendications 9 ou 10, **caractérisé en ce que** les fibres (9) ont une longueur d'au moins 50 mm.

12. Réflecteur selon les revendications 9 à 11, **caractérisé en ce que** l'épaisseur des fibres est ≤ 1 mm.

13. Réflecteur selon les revendications 9 à 12, **caractérisé en ce que** les fibres (9) sont réalisées en métal.
